# FASCICULE DE BREVET EUROPEEN

(11) **EP 3 974 851 B1**
(45) Date de publication et mention de la délivrance du brevet: **07.08.2024**
(21) Numéro de dépôt: 21195675.0
(22) Date de dépôt: 09.09.2021
(51) Int. Cl.: G01R 31/34, F04B 51/00, F04B 49/06

(54) **PROCEDE DE SURVEILLANCE DU FONCTIONNEMENT D'UNE MACHINE A PARTIR DE SIGNAUX DE COURANT ELECTRIQUE ET DISPOSITIF POUR LA MISE EN OEUVRE D'UN TEL PROCEDE**
VERFAHREN ZUR ÜBERWACHUNG DES BETRIEBS EINER MASCHINE AUF DER GRUNDLAGE ELEKTRISCHER STROMSIGNALE UND VORRICHTUNG ZUR UMSETZUNG EINES SOLCHEN VERFAHRENS
METHOD FOR MONITORING THE OPERATION OF A MACHINE FROM ELECTRIC CURRENT SIGNALS AND DEVICE FOR IMPLEMENTING SUCH A METHOD

(30) Priorité: 23.09.2020 FR 2009625
(43) Date de publication de la demande: 30.03.2022
(73) Titulaire: STMicroelectronics International N.V., 1228 Plan-les-Ouates, Geneva (CH)
(72) Inventeur: HUANG, He, 83000 Toulon (FR); DE GRIMAUDET DE ROCHEBOUET, François, 83000 Toulon (FR)
(74) Mandataire: Casalonga

(56) Documents cités:
- WO-A1-2020/058075
- FR-A1- 3 062 733

## Description

### DOMAINE TECHNIQUE DE L'INVENTION

Le domaine technique de l'invention est celui de la surveillance du fonctionnement de machines et plus particulièrement celui de la surveillance du fonctionnement de machines à partir de signaux de courant électrique.

La présente invention concerne un procédé de surveillance du fonctionnement d'une machine à partir de signaux de courant électrique et un dispositif pour la mise en oeuvre d'un tel procédé.

### ARRIERE-PLAN TECHNOLOGIQUE DE L'INVENTION

Pour détecter des anomalies dans le fonctionnement d'une machine telle qu'un moteur, une pompe, un compresseur, ou un ventilateur, il est connu d'étudier le courant électrique sortant de la machine, qui peut changer lorsque des pièces de la machine sont déficientes ou encrassées. La détection d'anomalies à partir du courant électrique présente notamment l'intérêt d'être indépendante de l'environnement de la machine, ce qui n'est pas le cas par exemple, d'une détection d'anomalies basée sur le profil des vibrations générées par la machine, qui pose notamment problème quand la machine est en mouvement ou à proximité d'une autre machine.

Des anomalies peuvent ainsi être identifiées avant qu'elles ne deviennent trop graves et n'entraînent des dégâts supplémentaires ou des interruptions imprévues. Pour cela, la machine est surveillée au moyen d'un capteur de courant électrique positionné sur la machine et un algorithme de détection d'anomalies est appliqué sur le courant mesuré par le capteur.

De tels algorithmes de détection d'anomalies utilisent classiquement des techniques de deep learning comme les réseaux de neurones, permettant d'obtenir des taux de détection élevés. De telles techniques nécessitent l'utilisation de processeurs puissants et d'une quantité importante de ressources mémoire pour être fonctionnelles.

FR 3 062 733 A1 concerne un procédé de surveillance comportant une phase de diagnostic pour évaluer un état d'un équipement, la phase de diagnostic comprenant: une étape d'apprentissage comportant: une première sous-étape d'apprentissage et de réglage d'un algorithme SVM selon une logique classique pour générer un modèle d'apprentissage net de classification des observations; une première sous-étape d'apprentissage et de réglage d'un algorithme SVM selon une logique floue pour générer un modèle d'apprentissage flou de classification des observations; une sous-étape de paramétrage d'une règle de décision automatique au moyen du modèle d'apprentissage net et du modèle d'apprentissage flou; une étape de diagnostic en opération consistant à acquérir en opération et à classifier de nouvelles observations.

Ainsi, ces techniques sont incompatibles avec une implémentation sur microcontrôleur contraint en termes de ressources mémoire mais ayant un haut degré d'intégration grâce à ses dimensions réduites.

Il existe donc un besoin de concevoir un algorithme de détection d'anomalies à partir de signaux de courant électrique, permettant d'obtenir des taux de détection comparables à ceux obtenus avec les techniques de deep learning, implémenté sur un microcontrôleur pouvant être embarqué sur n'importe quel système quel que soit son environnement.

### RESUME DE L'INVENTION

L'invention offre une solution aux problèmes évoqués précédemment, en permettant de détecter des anomalies à partir du courant électrique grâce à un algorithme implémenté sur un microcontrôleur ayant une haute capacité d'intégration.

Un premier aspect de l'invention concerne un procédé de surveillance mis en oeuvre par ordinateur, du fonctionnement d'une machine alimentée en courant électrique, comportant :
- une phase d'apprentissage du fonctionnement normal de la machine comprenant les étapes suivantes :
   - acquérir dans le domaine temporel un premier signal de courant électrique généré par la machine ;
   - déterminer une première signature de courant électrique correspondant au premier signal de courant électrique ;
   - déterminer un premier taux de similarité entre la première signature de courant électrique et chacune des signatures de courant électrique enregistrées dans un savoir ;
   - comparer le premier taux de similarité avec un premier seuil prédéterminé ;
   - si le premier taux de similarité est inférieur au premier seuil, enregistrer la signature de courant électrique dans le savoir ;
- une phase de surveillance comprenant les étapes suivantes :
   - acquérir dans le domaine temporel un deuxième signal de courant électrique généré par la machine ;
   - déterminer une deuxième signature de courant électrique correspondante au deuxième signal de courant électrique ;
   - déterminer un deuxième taux de similarité entre la deuxième signature de courant électrique et chacune des signatures de courant électrique enregistrées dans le savoir ;
   - comparer le deuxième taux de similarité avec un deuxième seuil prédéterminé ;
   - si le deuxième taux de similarité est inférieur au deuxième seuil, générer une alerte, la deuxième signature de courant électrique étant considérée comme révélatrice d'une anomalie ;
les étapes de la phase d'apprentissage étant répétées périodiquement de manière à constituer le savoir, les étapes de la phase de surveillance étant répétées périodiquement et le procédé de surveillance passant de manière autonome de la phase d'apprentissage à la phase de surveillance lorsque le savoir est considéré comme étant constitué.

Dans un premier temps, le procédé de surveillance apprend à reconnaître de manière autonome les signaux de courant électrique caractéristiques d'un fonctionnement normal de la machine. Ensuite, dans un deuxième temps, le procédé de surveillance acquiert et compare régulièrement des signaux de courant électrique afin de déterminer si la machine s'écarte de son fonctionnement normal. Grâce à l'invention, il est donc possible de détecter efficacement si une anomalie se produit et dans ce cas, de déclencher une alerte.

De plus, durant sa phase d'apprentissage, le procédé de surveillance enregistre uniquement les signatures de courant électrique suffisamment différentes des signatures déjà apprises, c'est-à-dire des signatures déjà enregistrées dans le savoir, ce qui permet d'éviter la redondance d'informations et de limiter le nombre de données stockées durant l'apprentissage sans diminuer la qualité de l'apprentissage. Le procédé de surveillance peut alors être implémenté sur des dispositifs contraints en termes de ressources, comme par exemple un microcontrôleur.

Outre les caractéristiques qui viennent d'être évoquées dans le paragraphe précédent, le procédé selon le premier aspect de l'invention peut présenter une ou plusieurs caractéristiques complémentaires parmi les suivantes, considérées individuellement ou selon toutes les combinaisons techniquement possibles.

Selon une variante de réalisation, la phase d'apprentissage comporte en outre une étape spécifique de comparaison du premier taux de similarité d'un nombre M prédéterminé de signatures de courant électrique déterminées consécutivement avec un seuil spécifique prédéterminé supérieur au premier seuil, le savoir étant considéré comme étant constitué si le premier taux de similarité des M dernières signatures de courant électrique est supérieur au seuil spécifique.

Selon une variante de réalisation compatible avec la variante de réalisation précédente, la phase de surveillance comporte une période dite « de découverte » au cours de laquelle la deuxième signature de courant électrique considérée comme révélatrice d'une anomalie est enregistrée dans le savoir.

Selon une variante de réalisation compatible avec les variantes de réalisation précédentes, la phase de surveillance comporte une étape de comparaison de la durée de l'anomalie avec une durée prédéterminée, l'anomalie étant avérée si la durée de l'anomalie est supérieure à la durée prédéterminée.

Selon une variante de réalisation compatible avec les variantes de réalisation précédentes, la phase de surveillance comporte en outre une étape de transmission de l'alerte.

Selon une variante de réalisation compatible avec les variantes de réalisation précédentes, la phase de surveillance comporte en outre une étape de transmission d'un rapport d'analyse effectuée périodiquement.

Selon une variante de réalisation compatible avec les variantes de réalisation précédentes, les étapes de la phase d'apprentissage sont répétées périodiquement selon une première période de répétition, les étapes de la phase de surveillance étant répétées périodiquement selon une deuxième période de répétition supérieure à la première période de répétition.

Selon une variante de réalisation compatible avec les variantes de réalisation précédentes, le deuxième seuil de la deuxième étape de comparaison est inférieur au premier seuil de la première étape de comparaison.

Un deuxième aspect de l'invention concerne un dispositif de surveillance configuré pour la mise en oeuvre d'un procédé selon le premier aspect de l'invention, le dispositif de surveillance étant destiné à être installé sur une machine alimentée en courant électrique, le dispositif étant caractérisé en ce qu'il comporte :
- un capteur de courant électrique adapté et configuré pour acquérir un signal de courant électrique ;
- un microcontrôleur adapté et configuré pour déterminer une signature de courant électrique correspondant au signal de courant électrique, déterminer un taux de similarité entre la signature de courant électrique et chacune des signatures de courant électrique enregistrées dans un savoir, et comparer le taux de similarité avec un seuil prédéterminé ;
- une mémoire adaptée et configurée pour enregistrer la signature de courant électrique.

Selon une variante de réalisation, le capteur de courant électrique est une pince ampèremétrique ou un contrôleur de moteur.

Un troisième aspect de l'invention concerne un produit-programme d'ordinateur comprenant des instructions qui, lorsque le programme est exécuté par un ordinateur, conduisent celui-ci à mettre en oeuvre les étapes du procédé selon le premier aspect de l'invention.

L'invention et ses différentes applications seront mieux comprises à la lecture de la description qui suit et à l'examen des figures qui l'accompagnent.

### BREVE DESCRIPTION DES FIGURES

Les figures sont présentées à titre indicatif et nullement limitatif de l'invention.
- La figure 1 est un diagramme fonctionnel d'un dispositif de surveillance du fonctionnement d'une machine selon un mode de réalisation de l'invention ;
- La figure 2 est un logigramme d'un procédé de surveillance du fonctionnement d'une machine selon un mode de mise en oeuvre de l'invention.

### DESCRIPTION DETAILLEE

Sauf précision contraire, un même élément apparaissant sur des figures différentes présente une référence unique.

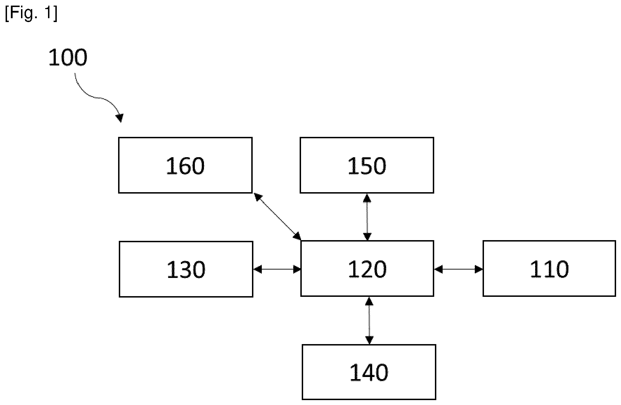

[Fig. 1] La figure 1 représente un mode de réalisation d'un dispositif de surveillance 100 selon l'invention.

Le dispositif de surveillance 100 est destiné à être installé sur une machine alimentée en énergie électrique.

La machine peut par exemple être un moteur, une pompe, un compresseur, un disjoncteur ou un ventilateur.

Le dispositif de surveillance 100 comporte un capteur de courant électrique 110, un microcontrôleur 120, une mémoire 130, un module de transmission de données 140, une alimentation électrique 150 et un organe d'activation 160.

Le capteur de courant électrique 110 est adapté et configuré pour acquérir un signal de courant électrique généré par la machine.

Le capteur de courant électrique 110 est par exemple une pince ampèremétrique ou un contrôleur de moteur qui utilise une mesure de courant pour régler la vitesse et la direction d'un moteur dans le cas où la machine comporte un moteur.

Le signal de courant électrique obtenu par le capteur de courant électrique 110 est transmis au microcontrôleur 120 dont le rôle est d'analyser le signal de courant électrique reçu. Le microcontrôleur 120 est notamment configuré pour déterminer une signature de courant électrique à partir du signal de courant électrique acquis par le capteur de courant électrique 110, comme décrit plus en détail par la suite. Le microcontrôleur 120 comporte par exemple un microprocesseur.

La mémoire 130 est adaptée et configurée pour enregistrer des signatures de courant électrique caractéristiques d'un fonctionnement normal de la machine. L'ensemble des signatures de courant électrique stockées dans la mémoire forment un savoir.

Le module de transmission de données 140 est adapté et configuré pour transmettre des rapports d'analyse de manière périodique, ainsi que des alertes lorsque des anomalies sont détectées. Ces données sont par exemple transmises à une console de supervision qui permet de visualiser les rapports d'analyse et de gérer les alertes. De préférence, le module de transmission utilise un réseau de communication sans fil de type internet des objets, également appelé IOT pour « Internet Of Things » selon la terminologie anglo-saxonne. Le réseau IOT peut par exemple utiliser la technologie LoRa ou la technologie Sigfox.

L'alimentation électrique 150 fournit l'énergie électrique nécessaire au fonctionnement du dispositif de surveillance 100. L'alimentation électrique 150 est avantageusement dimensionnée de manière que le dispositif de surveillance 100 fonctionne sans interruption pendant une période de temps prolongée, de l'ordre de plusieurs années. Afin de réduire la consommation d'énergie électrique, le dispositif de surveillance 100 est avantageusement configuré pour se mettre en veille entre chaque acquisition. L'alimentation électrique 150 comporte par exemple une batterie ou une pile.

L'organe d'activation 160 peut être utilisé pour mettre en fonctionnement ou arrêter le dispositif de surveillance 100. Avantageusement, le dispositif de surveillance 100 comporte un unique organe d'activation 160, ce qui facilite l'utilisation du dispositif de surveillance 100. Une fois que l'organe d'activation 160 est déclenché, le dispositif de surveillance 100 fonctionne de manière complétement autonome. L'organe d'activation 160 est par exemple un bouton poussoir ou un interrupteur.

Le dispositif de surveillance 100 comporte également des moyens de fixation (non représentés) configurés pour maintenir le dispositif de surveillance 100 sur la machine. Les moyens de fixation peuvent être par exemple des éléments magnétiques ou des éléments adhésifs.

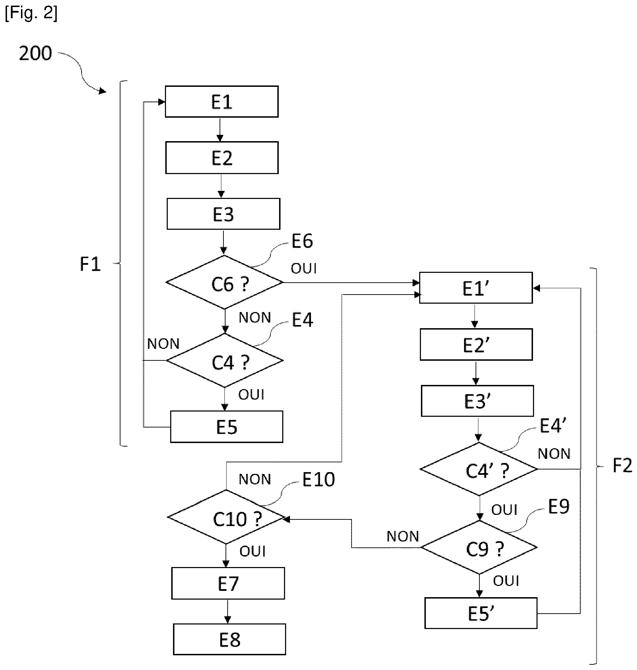

[Fig. 2] La figure 2 montre un mode de mise en oeuvre préférentiel d'un procédé de surveillance 200 selon l'invention.

Le procédé de surveillance 200 peut être mis en oeuvre par le dispositif de surveillance 100 de la figure 1.

Le procédé de surveillance 200 comporte une phase d'apprentissage F1 ayant pour but de constituer le savoir et une phase de surveillance F2 au cours de laquelle les signaux de courant électrique générés par la machine sont comparés au savoir afin de détecter des différences pouvant être révélatrices d'une anomalie dans la machine. Le procédé de surveillance 200 peut ainsi être utilisé pour faire de la maintenance prédictive.

La phase d'apprentissage F1 comporte une première étape E1 d'acquisition dans le domaine temporel d'un premier signal de courant électrique généré par la machine. Le signal de courant électrique est un échantillon de courant électrique mesuré en sortie de la machine correspondant à une première durée d'acquisition, de préférence comprise entre 1 seconde et 5 secondes. La première durée d'acquisition est par exemple égale à 2 secondes.

La première étape d'acquisition E1 est effectuée à une fréquence d'échantillonnage comprise par exemple, entre 500 Hz et 5000 Hz.

La première étape d'acquisition E1 est suivie d'une première étape E2 de détermination d'une signature de courant électrique correspondant au signal de courant électrique acquis à la première étape d'acquisition E1.

La signature de courant électrique est par exemple le signal de courant électrique précédemment acquis, ou le signal de courant électrique précédemment acquis ayant subi au moins un traitement comme par exemple un lissage de signal ou « signal smoothing » en anglais, pour éviter la dispersion du signal.

La signature de courant électrique peut également être déterminée à partir du signal de courant électrique précédemment acquis dans le domaine temporel, transformé en un signal de courant électrique dans le domaine fréquentiel, en effectuant par exemple une transformée de Fourier. Le signal de courant électrique dans le domaine fréquentiel s'étend sur une plage de fréquences qui dépend de la fréquence d'échantillonnage. Cette plage de fréquences est divisée en un nombre prédéterminé d'intervalles, par exemple égal à 128 ou à 256. Un coefficient est attribué à chaque intervalle de fréquence, chaque coefficient représentant l'intensité du signal de courant électrique dans l'intervalle de fréquence correspondant. La signature de courant électrique comporte donc une série de valeurs qui caractérisent le signal de courant électrique prélevé sur la machine. Ce type de signature de courant électrique est particulièrement avantageux dans le cas où la machine présente un fonctionnement cyclique.

On procède ensuite à une première étape E3 de détermination d'un premier taux de similarité SR1 entre la signature de courant électrique déterminée à la première étape E2 de détermination et les signatures de courant électrique présentes dans le savoir.

Les méthodes de calcul du taux de similarité sont connues de l'homme du métier et ne seront donc pas décrites plus en détail. De telles méthodes sont notamment utilisées dans le domaine de la reconnaissance d'empreintes digitales. À titre d'exemple non limitatif, le taux de similarité peut être déterminé par un calcul de distance dans un espace à N dimension où N est ici égal au nombre de coefficients que comporte la signature de courant électrique. Le taux de similarité peut être exprimé en pourcentage.

Le premier taux de similarité SR1 est ensuite comparé, au cours d'une première étape de comparaison E4, à un premier seuil TH1 prédéterminé. Si une première condition de comparaison C4 est vérifiée, c'est-à-dire si le premier taux de similarité SR1 est inférieur au premier seuil TH1, la première signature de courant électrique est considérée comme n'étant pas connue. Dans ce cas, la première signature de courant électrique est enregistrée dans le savoir au cours d'une première étape d'enregistrement E5. Par contre, si la première condition de comparaison C4 n'est pas vérifiée, c'est-à-dire si le premier taux de similarité SR1 est supérieur au premier seuil TH1, la première signature de courant électrique est considérée comme étant connue. Dans ce cas, la première signature de courant électrique n'est pas enregistrée dans le savoir.

Le premier seuil TH1 est par exemple fixé à 90 %.

Les étapes de la phase d'apprentissage F1 sont répétées périodiquement selon une première période de répétition. Le savoir, qui est initialement vide, est ainsi constitué au fur et à mesure. La première période de répétition est par exemple égale à une minute. Autrement dit, un nouveau signal de courant électrique est échantillonné toutes les minutes.

De préférence, la première période de répétition est régulière.

Avantageusement, la phase d'apprentissage F1 comporte également une étape spécifique de comparaison E6 du premier taux de similarité d'un nombre M prédéterminé de signatures de courant électrique déterminées consécutivement avec un seuil spécifique TH0 prédéterminé supérieur au premier seuil TH1.

L'étape spécifique de comparaison E6 est par exemple effectuée avant la première étape de comparaison E4 du taux de similarité avec le premier seuil TH1.

Si une condition spécifique de comparaison C6 est vérifiée, c'est-à-dire si le premier taux de similarité SR1 des M dernières signatures de courant électrique est supérieur au deuxième seuil TH0, le savoir est considéré comme étant constitué. Dans ce cas, la phase d'apprentissage F1 prend fin et le procédé de surveillance 200 passe à la phase de surveillance F2.

Si la condition spécifique de comparaison C6 n'est pas vérifiée, c'est-à-dire si le taux de similarité d'au moins l'une des M dernières signatures de courant électrique est inférieur au deuxième seuil TH0, la phase d'apprentissage F1 se poursuit.

À titre d'exemple non limitatif, la phase d'apprentissage F1 peut se terminer lorsque le taux de similarité des dix dernières signatures de courant électrique, qui correspondent donc aux dix derniers signaux de courant électrique acquis, est supérieur à 98 %.

La durée de la phase d'apprentissage F1 dépend de la machine sur laquelle le dispositif de surveillance 100 est installé mais dans tous les cas, la phase d'apprentissage F1 s'achève de manière autonome.

Selon un autre mode de mise en oeuvre, le savoir peut être considéré comme étant constitué à la fin d'une durée d'apprentissage prédéterminée. La durée d'apprentissage peut dans ce cas être paramétrée en fonction du type de machine sur laquelle le dispositif de surveillance 100 est destiné à être installé.

La phase d'apprentissage F1 est suivie de la phase de surveillance F2 qui comprend une deuxième étape E1' d'acquisition d'un deuxième signal de courant électrique, une deuxième étape E2' de détermination d'une deuxième signature de courant électrique correspondant au deuxième signal de courant électrique et une deuxième étape E3' de détermination d'un deuxième taux de similarité de la deuxième signature de courant électrique.

Ces deuxièmes étapes E1', E2', E3' effectuées pendant la phase de surveillance F2 sont similaires aux premières étapes E1, E2, E3 de même nom effectuées pendant la phase d'apprentissage F1.

La durée de la deuxième étape d'acquisition E1' est de préférence identique à la durée de la première étape d'acquisition E1. Alternativement, la durée des étapes d'acquisition E1, E1' peuvent être différentes.

Pendant la phase de surveillance F2, le deuxième taux de similarité SR2 est comparé, au cours d'une deuxième étape de comparaison E4', à un deuxième seuil TH2 prédéterminé inférieur au premier seuil TH1. Si une deuxième condition de comparaison C4' est vérifiée, c'est-à-dire si le deuxième taux de similarité SR2 est supérieur au deuxième seuil TH2, on considère que la deuxième signature de courant électrique est connue. Si la deuxième condition de comparaison C4' n'est pas vérifiée, c'est-à-dire si le deuxième taux de similarité SR' est inférieur au deuxième seuil TH2, on considère que la deuxième signature de courant électrique n'est pas connue et est révélatrice d'une anomalie au niveau de la machine.

Le deuxième seuil TH2 est par exemple fixé à 80 %.

La phase de surveillance F2 comporte une étape E7 de génération d'une alerte lorsqu'une anomalie est reconnue. L'alerte peut ensuite être transmise au cours d'une étape E8 de transmission. Un opérateur peut ainsi est être averti qu'une anomalie au niveau de la machine a été détectée.

Outre l'envoi d'une alerte, la phase de surveillance F2 peut également comporter une étape de transmission (non représentée) d'un rapport d'analyse du courant électrique en sortie de la machine. Le rapport d'analyse comporte par exemple des informations relatives à l'amplitude du courant électrique et en particulier des éventuelles anomalies. Le rapport d'analyse peut également indiquer les temps de fonctionnement et d'arrêt de la machine. La transmission du rapport d'analyse est effectuée régulièrement, par exemple toutes les deux heures.

Dans ce mode de réalisation préférentiel, la phase de surveillance F2 comporte une période dite « de découverte » qui débute en même temps que la phase de surveillance F2. Avantageusement, la phase de surveillance F2 comporte une étape de vérification E9 effectuée avant de générer l'alerte et au cours de laquelle on vérifie si une condition de vérification C9 est vérifiée, c'est-à-dire si le deuxième signal de courant électrique, correspondant à la deuxième signature de courant électrique révélatrice d'une anomalie, a été acquis pendant la période de découverte.

Si la condition de vérification C9 n'est pas vérifiée, c'est-à-dire si le deuxième signal de courant électrique n'a pas été acquis pendant la période de découverte, l'étape E7 de génération d'une alerte peut être réalisée.

Si la condition de vérification C9 est vérifiée, la deuxième signature de courant électrique est enregistrée dans le savoir au cours d'une étape d'enregistrement E5' et l'étape E7 de génération d'une alerte n'est pas réalisée. Autrement dit, on considère qu'il ne s'agit pas vraiment d'une anomalie mais d'un courant électrique caractéristique du fonctionnement normal de la machine qui n'a pas été présenté pendant la phase d'apprentissage F1.

Ainsi, au cours de la période de découverte, le savoir peut être enrichi. La période de découverte est particulièrement utile pour des machines ayant des cycles de fonctionnement qui sont variables dans le temps.

De préférence, la période de découverte présente une durée prédéterminée par exemple égale à sept jours.

Avantageusement, la phase de surveillance F2 comporte une étape E10 de comparaison de la durée de l'anomalie T_{A} avec une durée prédéterminée T₀.

Si une condition de comparaison de durée C10 est vérifiée, c'est-à-dire si la durée de l'anomalie T_{A} est supérieure à la durée prédéterminée T₀, l'étape E7 de génération d'une alerte est réalisée. Dans ce cas, on considère en effet que l'anomalie est avérée.

Si la condition de comparaison de durée C10 n'est pas vérifiée, c'est-à-dire si la durée de l'anomalie T_{A} est inférieure à la durée prédéterminée T₀, l'étape E7 de génération d'une alerte n'est pas réalisée.

Cette étape E10 de comparaison permet d'éviter de déclencher des alertes de manière intempestive, par exemple lorsque la machine subit un événement ponctuel, tel qu'une coupure de courant, qui entraînerait une modification du courant électrique.

Les étapes de la phase de surveillance F2 sont répétées périodiquement selon une deuxième période de répétition.

Avantageusement, la deuxième période de répétition est supérieure à la première période de répétition afin de minimiser la consommation d'énergie électrique et donc de prolonger la durée de fonctionnement du dispositif de surveillance 100.

La deuxième période de répétition est par exemple égale à deux minutes.

La deuxième période de répétition peut être dynamique, c'est-à-dire qu'elle peut varier, et en particulier diminuer, lorsqu'une anomalie est détectée. Un avantage est de permettre une caractérisation plus précise de l'anomalie, notamment en ce qui concerne sa durée.

Naturellement, l'invention n'est pas limitée aux modes de réalisation décrits en référence aux figures et des variantes pourraient être envisagées sans sortir du cadre de l'invention.

## Revendications

1. Procédé de surveillance (200) mis en oeuvre par ordinateur, du fonctionnement d'une machine alimentée en courant électrique, **caractérisé en ce qu'**il comporte :
- une phase d'apprentissage (F1) du fonctionnement normal de la machine comprenant les étapes suivantes :
o (E1) acquérir dans le domaine temporel un premier signal de courant électrique généré par la machine ;
o (E2) déterminer une première signature de courant électrique correspondant au premier signal de courant électrique ;
o (E3) déterminer un premier taux de similarité (SR1) entre la première signature de courant électrique et chacune des signatures de courant électrique enregistrées dans un savoir ;
o (E4) comparer le premier taux de similarité (SR1) avec un premier seuil (TH1) prédéterminé ;
o (E5) si le premier taux de similarité (SR1) est inférieur au premier seuil (TH1), enregistrer la signature de courant électrique dans le savoir ;
- une phase de surveillance (F2) comprenant les étapes suivantes :
o (E1') acquérir dans le domaine temporel un deuxième signal de courant électrique généré par la machine ;
o (E2') déterminer une deuxième signature de courant électrique correspondante au deuxième signal de courant électrique ;
o (E3') déterminer un deuxième taux de similarité (SR2) entre la deuxième signature de courant électrique et chacune des signatures de courant électrique enregistrées dans le savoir ;
o (E4') comparer le deuxième taux de similarité (SR2) avec un deuxième seuil (TH2) prédéterminé ;
o (E7) si le deuxième taux de similarité (SR2) est inférieur au deuxième seuil (TH2), générer une alerte, la deuxième signature de courant électrique étant considérée comme révélatrice d'une anomalie ;
les étapes (E1 à E5) de la phase d'apprentissage étant répétées périodiquement de manière à constituer le savoir, les étapes (E1' à E7) de la phase de surveillance étant répétées périodiquement et le procédé de surveillance (200) passant de manière autonome de la phase d'apprentissage (F1) à la phase de surveillance (F2) lorsque le savoir est considéré comme étant constitué.

2. Procédé (200) selon la revendication 1, **caractérisé en ce que** la phase d'apprentissage (F1) comporte en outre une étape spécifique (E6) de comparaison du premier taux de similarité (SR1) d'un nombre M prédéterminé de signatures de courant électrique déterminées consécutivement avec un seuil spécifique (TH0) prédéterminé supérieur au premier seuil (TH1), le savoir étant considéré comme étant constitué si le premier taux de similarité (SR1) des M dernières signatures de courant électrique est supérieur au seuil spécifique (TH0).

3. Procédé (200) selon l'une quelconque des revendications 1 et 2, **caractérisé en ce que** la phase de surveillance (F2) comporte une période dite « de découverte » au cours de laquelle la deuxième signature de courant électrique considérée comme révélatrice d'une anomalie est enregistrée dans le savoir.

4. Procédé (200) selon l'une quelconque des revendications 1 à 3, **caractérisé en ce que** la phase de surveillance (F2) comporte une étape (E10) de comparaison de la durée de l'anomalie avec une durée prédéterminée, l'anomalie étant avérée si la durée de l'anomalie est supérieure à la durée prédéterminée.

5. Procédé (200) selon l'une quelconque des revendications 1 à 4, **caractérisé en ce que** la phase de surveillance (F2) comporte en outre une étape (E8) de transmission de l'alerte.

6. Procédé (200) selon l'une quelconque des revendications 1 à 5, **caractérisé en ce que** la phase de surveillance (F2) comporte en outre une étape de transmission d'un rapport d'analyse effectuée périodiquement.

7. Procédé (200) selon l'une quelconque des revendications 1 à 6, **caractérisé en ce que** les étapes (E1 à E5) de la phase d'apprentissage (F1) sont répétées périodiquement selon une première période de répétition, les étapes (E1' à E7) de la phase de surveillance (F2) étant répétées périodiquement selon une deuxième période de répétition supérieure à la première période de répétition.

8. Procédé (200) selon l'une quelconque des revendications 1 à 7, **caractérisé en ce que** le deuxième seuil (TH2) de la deuxième étape (E4') de comparaison est inférieur au premier seuil (TH1) de la première étape (E4) de comparaison.

9. Dispositif de surveillance (100) configuré pour la mise en oeuvre d'un procédé (200) selon l'une quelconque des revendications 1 à 8, le dispositif de surveillance (100) étant destiné à être installé sur une machine alimentée en courant électrique, le dispositif étant **caractérisé en ce qu'**il comporte :
- un capteur de courant électrique (110) adapté et configuré pour acquérir (E1, E1') un signal de courant électrique ;
- un microcontrôleur (120) adapté et configuré pour déterminer (E2, E2') une signature de courant électrique correspondant au signal de courant électrique, déterminer (E3, E3') un taux de similarité entre la signature de courant électrique et chacune des signatures de courant électrique enregistrées dans un savoir, et comparer (E4, E4') le taux de similarité avec un seuil prédéterminé (TH1, TH2) ;
- une mémoire (130) adaptée et configurée pour enregistrer la signature de courant électrique.

10. Produit-programme d'ordinateur comprenant des instructions qui, lorsque le programme est exécuté par un ordinateur, conduisent celui-ci à mettre en oeuvre les étapes du procédé (200) selon l'une quelconque des revendications 1 à 8.

## Patentansprüche

1. Computerimplementiertes Verfahren zur Überwachung (200) des Betriebs einer Maschine, die mit Strom versorgt wird, **dadurch gekennzeichnet, dass** es umfasst:
- eine Lernphase (F1) des Normalbetriebs der Maschine, die die folgenden Schritte umfasst:
-- (E1) Erfassen eines ersten Stromsignals, das von der Maschine erzeugt wird, im Zeitbereich;
-- (E2) Bestimmen einer ersten Stromsignatur, die dem ersten Stromsignal entspricht;
-- (E3) Bestimmen einer ersten Ähnlichkeitsrate (SR1) zwischen der ersten Stromsignatur und jeder der Stromsignaturen, die in einem Verzeichnis gespeichert sind;
-- (E4) Vergleichen der ersten Ähnlichkeitsrate (SR1) mit einer ersten vorbestimmten Schwelle (TH1);
-- (E5) wenn die erste Ähnlichkeitsrate (SR1) kleiner ist als die erste Schwelle (TH1), Speichern der Stromsignatur im Verzeichnis;
- eine Überwachungsphase (F2), die die folgenden Schritte umfasst:
-- (E1') Erfassen eines zweiten Stromsignals, das von der Maschine erzeugt wird, im Zeitbereich;
-- (E2') Bestimmen einer zweiten Stromsignatur, die dem zweiten Stromsignal entspricht;
-- (E3') Bestimmen einer zweiten Ähnlichkeitsrate (SR2) zwischen der zweiten Stromsignatur und jeder der Stromsignaturen, die im Verzeichnis gespeichert sind;
-- (E4') Vergleichen der zweiten Ähnlichkeitsrate (SR2) mit einer vorbestimmten zweiten Schwelle (TH2);
-- (E7) wenn die zweite Ähnlichkeitsrate (SR2) kleiner ist als die zweite Schwelle (TH2), Erzeugen eines Alarms, wobei die zweite Stromsignatur als auf eine Anomalie hindeutend betrachtet wird;
wobei die Schritte (E1 bis E5) der Lernphase periodisch wiederholt werden, um das Verzeichnis aufzubauen, wobei die Schritte (E1' bis E7) der Überwachungsphase periodisch wiederholt werden und das Überwachungsverfahren (200) eigenständig von der Lernphase (F1) in die Überwachungsphase (F2) übergeht, wenn das Verzeichnis als aufgebaut betrachtet wird.

2. Verfahren (200) nach Anspruch 1, **dadurch gekennzeichnet, dass** die Lernphase (F1) weiter einen spezifischen Schritt (E6) des Vergleichens der ersten Ähnlichkeitsrate (SR1) einer vorbestimmten Anzahl M von Stromsignaturen, die aufeinanderfolgend bestimmt wurden, mit einer vorbestimmten spezifischen Schwelle (TH0) umfasst, die größer ist als die erste Schwelle (TH1), wobei das Verzeichnis als aufgebaut betrachtet wird, wenn die erste Ähnlichkeitsrate (SR1) der M letzten Stromsignaturen größer ist als die spezifische Schwelle (TH0).

3. Verfahren (200) nach einem der Ansprüche 1 und 2, **dadurch gekennzeichnet, dass** die Überwachungsphase (F2) eine sogenannte "Entdeckungsperiode" umfasst, in der die zweite Stromsignatur, die als auf eine Anomalie hindeutend betrachtet wird, im Verzeichnis gespeichert wird.

4. Verfahren (200) nach einem der Ansprüche 1 bis 3, **dadurch gekennzeichnet, dass** die Überwachungsphase (F2) einen Schritt (E10) des Vergleichens der Dauer der Anomalie mit einer vorbestimmten Dauer umfasst, wobei die Anomalie erwiesen ist, wenn die Dauer der Anomalie größer ist als die vorbestimmte Dauer.

5. Verfahren (200) nach einem der Ansprüche 1 bis 4, **dadurch gekennzeichnet, dass** die Überwachungsphase (F2) weiter einen Schritt (E8) des Übertragens des Alarms umfasst.

6. Verfahren (200) nach einem der Ansprüche 1 bis 5, **dadurch gekennzeichnet, dass** die Überwachungsphase (F2) weiter einen Schritt des Übertragens eines Analyseberichts umfasst, der periodisch ausgeführt wird.

7. Verfahren (200) nach einem der Ansprüche 1 bis 6, **dadurch gekennzeichnet, dass** die Schritte (E1 bis E5) der Lernphase (F1) periodisch gemäß einer ersten Wiederholungsperiode wiederholt werden, wobei die Schritte (E1' bis E7) der Überwachungsphase (F2) periodisch gemäß einer zweiten Wiederholungsperiode wiederholt werden, die größer ist als die erste Wiederholungsperiode.

8. Verfahren (200) nach einem der Ansprüche 1 bis 7, **dadurch gekennzeichnet, dass** die zweite Schwelle (TH2) des zweiten Vergleichsschritts (E4') kleiner ist als die erste Schwelle (TH1) des ersten Vergleichsschritts (E4).

9. Überwachungsvorrichtung (100), die zur Implementierung eines Verfahrens (200) nach einem der Ansprüche 1 bis 8 konfiguriert ist, wobei die Überwachungsvorrichtung (100) dazu bestimmt ist, an einer Maschine installiert zu werden, die mit Strom versorgt wird, wobei die Vorrichtung **dadurch gekennzeichnet ist, dass** sie umfasst:
- einen Stromsensor (110), der geeignet und konfiguriert ist, um ein Stromsignal zu erfassen (E1, E1');
- eine Mikrosteuerung (120), die geeignet und konfiguriert ist, um eine Stromsignatur zu bestimmen (E2, E2'), die dem Stromsignal entspricht, eine Ähnlichkeitsrate zwischen der Stromsignatur und jeder der Stromsignaturen, die in einem Verzeichnis gespeichert sind, zu bestimmen (E3, E3'), und die Ähnlichkeitsrate mit einer vorbestimmten Schwelle (TH1, TH2) zu vergleichen (E4, E4');
- einen Speicher (130), der geeignet und konfiguriert ist, um die Stromsignatur zu speichern.

10. Computerprogrammprodukt, das Anweisungen umfasst, die, wenn das Programm von einem Computer ausgeführt wird, diesen dazu bringen, die Schritte des Verfahrens (200) nach einem der Ansprüche 1 bis 8 zu implementieren.

## Claims

1. A computer-implemented monitoring method (200) of the operation of a machine supplied with electrical current, **characterised in that** it includes:
- a learning phase (F1) of the normal operation of the machine comprising the following steps:
o (E1) acquiring in the temporal domain a first electrical current signal generated by the machine;
o (E2) determining a first electrical current signature corresponding to the first electrical current signal;
o (E3) determining a first similarity rate (SR1) between the first electrical current signature and each of the electrical current signatures recorded in a knowledge;
o (E4) comparing the first similarity rate (SR1) with a first predetermined threshold (TH1) ;
o (E5) if the first similarity rate (SR1) is less than the first threshold (TH1), recording the electrical current signature in the knowledge;
- a monitoring phase (F2) comprising the following steps:
o (E1') acquiring in the temporal domain a second electrical current signal generated by the machine;
o (E2') determining a second electrical current signature corresponding to the second electrical current signal;
o (E3') determining a second similarity rate (SR2) between the second electrical current signature and each of the electrical current signatures recorded in the knowledge;
o (E4') comparing the second similarity rate (SR2) with a second predetermined threshold (TH2);
o (E7) if the second similarity rate (SR2) is less than the second threshold (TH2), generating an alert, the second electrical current signal being considered to reveal an anomaly;
the steps (E1 to E5) of the learning phase being repeated periodically in such a way as to constitute the knowledge, the steps (E1' to E7) of the monitoring phase being repeated periodically and the monitoring method (200) passing autonomously from the learning phase (F1) to the monitoring phase (F2) when the knowledge is considered to be constituted.

2. The method (200) according to claim 1, **characterised in that** the learning phase (F1) further includes a specific step (E6) of comparison of the first similarity rate (SR1) of a predetermined number M of electrical current signatures determined consecutively with a predetermined specific threshold (TH0) greater than the first threshold (TH1), the knowledge being considered to be constituted if the first similarity rate (SR1) of the M last electrical current signatures is greater than the specific threshold (TH).

3. The method (200) according to any one of claims 1 and 2, **characterised in that** the monitoring phase (F2) includes a so-called "discovery" period during which the second electrical current signature considered to reveal an anomaly is recorded in the knowledge.

4. The method (200) according to any one of claims 1 to 3, **characterised in that** the monitoring phase (F2) includes a step (E10) of comparison of the duration of the anomaly with a predetermined duration, the anomaly being proven if the duration of the anomaly is greater than the predetermined duration.

5. The method (200) according to any one of claims 1 to 4, **characterised in that** the monitoring phase (F2) further includes a step (E8) of transmission of the alert.

6. The method (200) according to any one of claims 1 to 5, **characterised in that** the monitoring phase (F2) further includes a step of transmission of an analysis report performed periodically.

7. The method (200) according to any one of claims 1 to 6, **characterised in that** the steps (E1 to E5) of the learning phase (F1) are repeated periodically according to a first repetition period, the steps (E1' to E7) of the monitoring phase (F2) being repeated periodically according to a second repetition period greater than the first repetition period.

8. The method (200) according to any one of claims 1 to 7, **characterised in that** the second threshold (TH2) of the second comparison step (E4') is less than the first threshold (TH1) of the first comparison step (E4).

9. A monitoring device (100) configured for the implementation of a method (200) according to any one of claims 1 to 8, the monitoring device (100) being intended to be installed on a machine supplied with electrical current, the device being **characterised in that** it includes:
- an electrical current sensor (110) adapted and configured to acquire (E1, E1') an electrical current signal;
- a microcontroller (120) adapted and configured to determine (E2, E2') an electrical current signature corresponding to the electrical current signal, determine (E3, E3') a similarity rate between the electrical current signature and each of the electrical current signatures recorded in a knowledge, and compare (E4, E4') the similarity rate with a predetermined threshold (TH1, TH2);
- a memory (130) adapted and configured to record the electrical current signature.

10. A computer programme product comprising instructions which, when the programme is executed by a computer, cause it to implement the steps of the method (200) according to any one of claims 1 to 8.
